# EUROPEAN PATENT APPLICATION

(11) **EP 4 464 733 A1**
(43) Date of publication of application: **20.11.2024**
(21) Application number: 23799681.4
(22) Date of filing: 03.05.2023
(51) Int. Cl.: C08G 61/02, C08L 65/00, C08L 61/24, C08L 61/28, C08K 5/3445, H01L 21/033

(54) **ORGANIC POLYMER, SEMICONDUCTOR HARD MASK COMPOSITION COMPRISING SAME, AND PATTERNING METHOD USING SAME**

(30) Priority: 03.05.2022 KR 20220054506
(71) Applicant: Hunetplus Co., Ltd., Chungcheongnam-do 31075 (KR)
(72) Inventor: CHA, Hyuk Jin, Seoul 06191 (KR); LEE, Keun Joo, Incheon 21376 (KR); KIM, Deogbae, Anyang-si Gyeonggi-do 14074 (KR); KIM, Keun Soo, Daejeon 35244 (KR)
(74) Representative: Prüfer & Partner mbB Patentanwälte · Rechtsanwälte
(86) International application number: PCT/KR2023/006050
(87) International publication number: WO 2023/214800

(57) **Abstract**

Disclosed is a hard mask polymer for semiconductor applications including a polymer of specific monomeric components, achieving improved etch resistance, solubility, and mechanical properties. The hard mask polymer is an organic polymer including a structure represented by Formula 1: 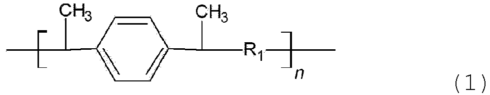 wherein R₁ is a hydrocarbon including one or more benzene ring structures and n is an integer from 1 to 10000. Also disclosed are a hard mask composition for semiconductor applications including the organic polymer and a patterning method using the hard mask composition.

## Description

### [Technical Field]

The present invention relates to an organic polymer, a hard mask composition for semiconductor applications including the organic polymer, and a patterning method using the hard mask composition. More specifically, the present invention relates to an organic polymer including a polymer of specific monomeric components, achieving improved etch resistance, solubility, and mechanical properties, a hard mask composition for semiconductor applications including the organic polymer, and a patterning method using the hard mask composition.

### [Background Art]

There is a continuous demand in the semiconductor industry to reduce the size of structural features. Efficient lithography techniques are essential to meet this.

Light sources with a narrower wavelength band are required to form finer photoresist patterns in lithography processes. An i-line light source with a wavelength of 365 nm was actually used in the past. Since then, lithography techniques using ArF (198 nm) and extreme ultraviolet (EUV, 13.5 nm) light sources starting from KrF (248 nm) have been developed to form finer patterns.

Photoresists become gradually thinner with decreasing size of patterns in order to prevent the photoresist patterns from collapsing. However, the use of thin photoresist patterns limits the etch depth of etching target layers.

In an attempt to solve this problem, a layer material with good etch resistance is introduced between a photoresist layer and an etching target layer. This layer material is called a hard mask. According to a hard mask process, a hard mask is patterned by etching using a photoresist pattern and an etching target layer is etched using the hard mask pattern. The hard mask is formed by chemical vapor deposition or spin coating.

However, chemical vapor deposition has disadvantages such as increased investment costs for equipment, increased processing time, and particle defects. Due to these disadvantages, efforts have continued to develop materials applicable to spin coating.

Although many hard mask materials are known in the art, however, they are limited in their direct application to spin coating, as discussed above. Thus, there is a need for a better material that simultaneously meets the requirements in terms of etch resistance, solubility, and storage stability.

### [Prior Art Document]

### [Patent Document]

(Patent Document 1) (0001) Korean Patent No. 10-0874655
(Patent Document 2) (0002) Korean Patent No. 10-1082104

### [Disclosure]

### [Technical Problem]

The present invention has been made in view of the above-described problems and is intended to provide an organic polymer including a polymer of specific monomeric components, achieving improved etch resistance, solubility, and mechanical properties, a hard mask composition for semiconductor applications including the organic polymer, and a patterning method using the hard mask composition.

### [Technical Solution]

the present invention provides a hard mask polymer for semiconductor applications including a structure represented by Formula 1: 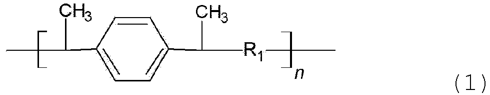
wherein R₁ is a hydrocarbon including one or more benzene ring structures and n is an integer from 1 to 10000.

In one embodiment, the hydrocarbon including benzene ring structures may have a structure represented by Formula 2 or 3: 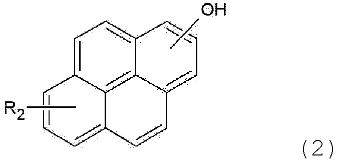
wherein R₂ is H, OH or a C₁-C₅ hydrocarbon, 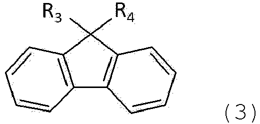
wherein R₃ and R₄ are each independently a benzene, naphthalene or biphenyl unsubstituted or substituted with OH or a C₁-C₅ hydrocarbon, with the proviso that R₃ and R₄ are optionally linked via a hydrocarbon or ether group to form a ring structure or are optionally each independently bonded to each ether.

In one embodiment, the structure of Formula 3 may be represented by one of Formulas 4 to 8:

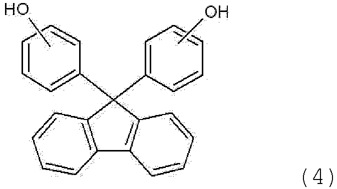

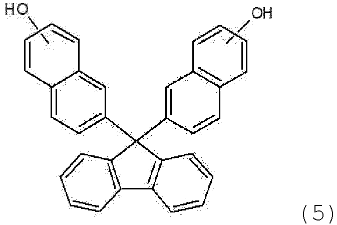

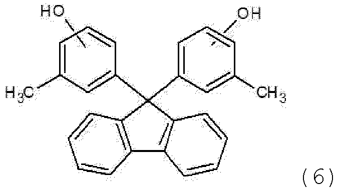

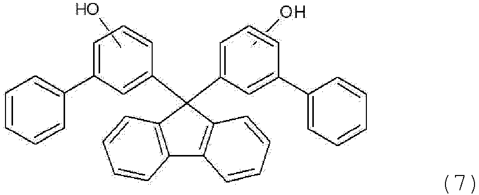

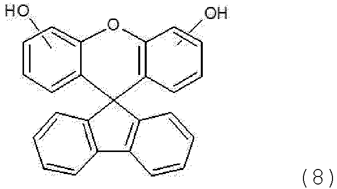

In one embodiment, the hard mask polymer for semiconductor applications may include a structure represented by Formula 9: 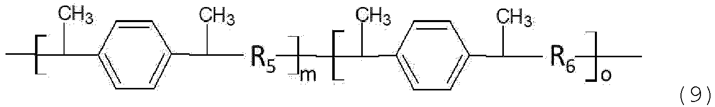 wherein R₅ and R₆ are each independently a hydrocarbon including one or more benzene ring structures and m and o are each independently an integer from 1 to 10000.

In one embodiment, R₅ may have a structure represented by Formula 10: 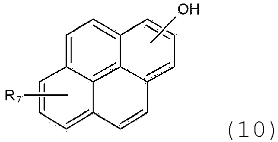
wherein R₇ is H, OH or a C₁-C₅ hydrocarbon, and
R₆ may have a structure represented by Formula 11: 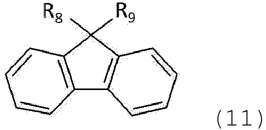
wherein R₈ and R₉ are each independently a benzene, naphthalene or biphenyl unsubstituted or substituted with OH or a C₁-C₅ hydrocarbon, with the proviso that R₈ and R₉ are optionally linked via a hydrocarbon or ether group to form a ring structure or are optionally each independently bonded to each ether.

In one embodiment, the structure of Formula 11 may be represented by one of Formulas 12 to 16:

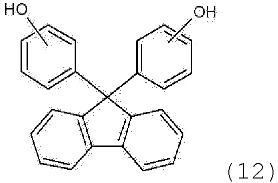

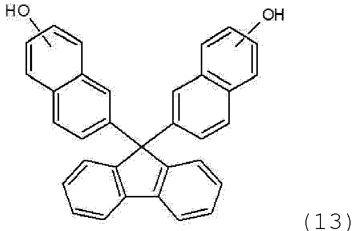

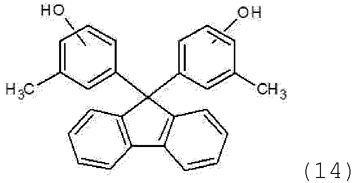

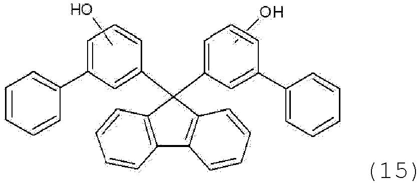

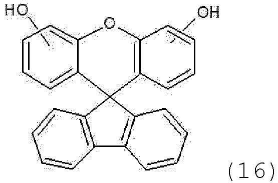

In one embodiment, the hard mask polymer for semiconductor applications may have a weight average molecular weight of 1,000 to 20,000.

The present invention also provides a hard mask composition for semiconductor applications including the hard mask polymer.

In one embodiment, the hard mask composition may include 100 parts by weight of an organic solvent, 1 to 20 parts by weight of the hard mask polymer for semiconductor applications, 0.1 to 3 parts by weight of a crosslinking agent, and 0.001 to 0.1 parts by weight of a catalyst.

In one embodiment, the organic solvent may be selected from the group consisting of propylene glycol monomethyl ether (PGME), propylene glycol methyl ether acetate (PGMEA), cyclohexanone, butyrolactone, ethyl lactate, N-methylpyrrolidone (NMP), methyl methoxypropionate (MMP), ethyl ethoxypropionate (EEP), dimethylformamide (DMF), and mixtures thereof.

In one embodiment, the crosslinking agent may be a methylated melamine resin, a methylated urea resin or the glycoluril derivative represented by Formula 17:

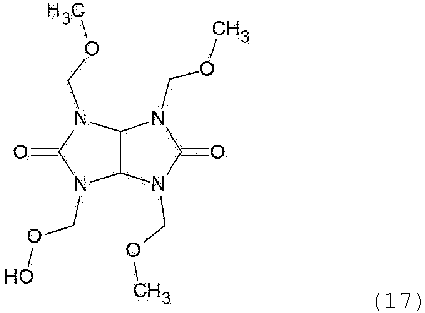

In one embodiment, the catalyst may be pyridinium p-toluenesulfonate, 2,4,4,6-tetrabromocyclohexadienone, benzoin tosylate or an alkyl ester of an organic sulfonic acid.

The present invention also provides a patterning method using the hard mask composition.

### [Advantageous Effects]

Due to their high etch selectivity and solubility, the organic polymer and the hard mask composition of the present invention can be applied to spin coating and their use can provide a patterning process that involves lower cost and defective rate than the use of conventional hard masks formed by chemical vapor deposition.

In addition, the presence of divinylbenzene repeating units and aromatic rings in the organic polymer allows the hard mask composition to have good etch resistance, high etch selectivity, and high solubility.

### [Mode for Invention]

Preferred embodiments of the present invention will now be described in detail. In the description of the present invention, detailed explanations of related art are omitted when it is deemed that they may unnecessarily obscure the essence of the present invention. Throughout the specification, the singular forms "a", "an" and "the" are intended to include the plural forms as well, unless the context clearly indicates otherwise. It is to be understood that the terms such as "including" or "having," etc., are intended to indicate the existence of the features, numbers, steps, operations, components, parts, or combinations thereof disclosed in the specification, and are not intended to preclude the possibility that one or more other features, numbers, steps, operations, components, parts, or combinations thereof may exist or may be added. Respective steps of the methods described herein may be performed in a different order than that which is explicitly described. In other words, the respective steps may be performed in the same order as described, substantially simultaneously, or in a reverse order.

The present disclosure is not limited to the illustrated embodiments and may be embodied in various different forms. Rather, the disclosed embodiments are provided so that this disclosure will be thorough and complete, and will fully convey the scope and spirit of the invention to those skilled in the art. In the drawings, the dimensions, such as widths and thicknesses, of elements may be exaggerated for clarity. The drawings are explained from an observer's point of view. It will be understood that when an element is referred to as being "on" another element, it can be directly on the other element, or one or more intervening elements may also be present therebetween. It will be understood by those skilled in the art that the present invention may be embodied in various different forms without departing from the spirit and scope of the invention as defined by the appended claims. The same reference numerals represent substantially the same elements throughout the drawings.

As used herein, the term "and/or" encompasses both combinations of the plurality of related items disclosed and any item from among the plurality of related items disclosed. In the present specification, the description "A or B" means "A", "B", or "A and B."

The present invention is directed to a hard mask polymer for semiconductor applications including a structure represented by Formula 1: 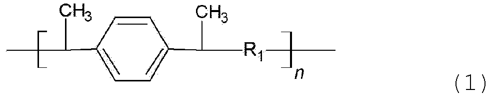 wherein R₁ is a hydrocarbon including one or more benzene ring structures and n is an integer from 1 to 10000.

The hard mask polymer includes, as a monomer, a copolymer of divinylbenzene and a hydrocarbon including benzene ring structures, as depicted in Formula 1.

The hydrocarbon including benzene ring structures may have a structure represented by Formula 2 or 3: 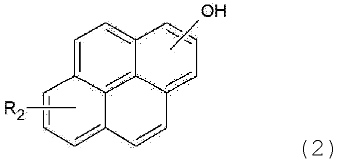
wherein R₂ is H, OH or a C₁-C₅ hydrocarbon, 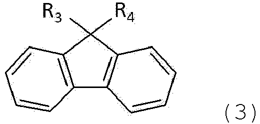
wherein R₃ and R₄ are each independently a benzene, naphthalene or biphenyl unsubstituted or substituted with OH or a C₁-C₅ hydrocarbon, with the proviso that R₃ and R₄ are optionally linked via a hydrocarbon or ether group to form a ring structure or are optionally each independently bonded to each ether.

The hydrocarbon including benzene ring structures may be a substituted or unsubstituted fluorene derivative or a substituted or unsubstituted pyrene derivative.

Specifically, the structure of Formula 3 may be represented by one of Formulas 4 to 8:

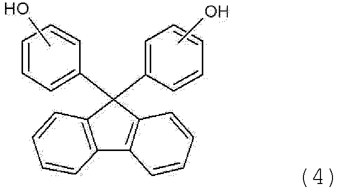

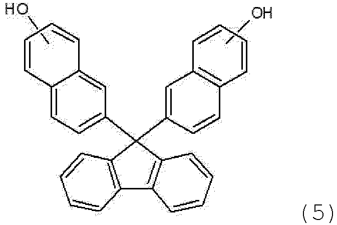

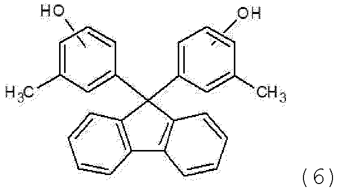

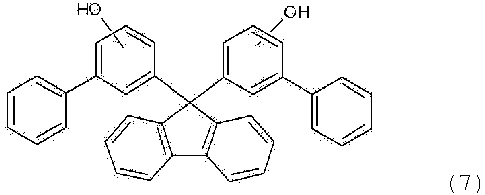

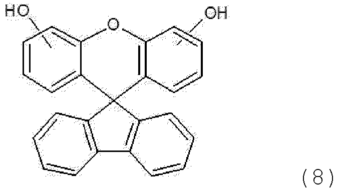

As describe above, the hydrocarbon including benzene ring structures may be a substituted or unsubstituted fluorene derivative or a substituted or unsubstituted pyrene derivative. The polycyclic structure may be optionally substituted with one or several atoms to form the monomer.

The term "substituted" in the expression of "substituted or unsubstituted" described herein means that one or more hydrogen atoms in the hydrocarbon are each independently replaced by the same or different substituents.

Suitable substituents include, but are not limited to, - F, -Cl, -Br, -CN, -NO₂-, OH, C₁-C₂₀ alkyl groups unsubstituted or substituted with -F, -Cl, -Br, -CN, -NO₂ or -OH, C₁-C₂₀ alkoxy groups unsubstituted or substituted with -F, -Cl, -Br, -CN, -NO₂ or -OH, C₆-C₃₀ aryl groups unsubstituted or substituted with C₁-C₂₀ alkyl, C₁-C₂₀ alkoxy, -F, -Cl, -Br, -CN, -NO₂ or -OH, C₆-C₃₀ heteroaryl groups unsubstituted or substituted with C₁-C₂₀ alkyl, C₁-C₂₀ alkoxy, -F, -Cl, -Br, -CN, -NO₂ or -OH, C₅-C₂₀ cycloalkyl groups unsubstituted or substituted with C₁-C₂₀ alkyl, C₁-C₂₀ alkoxy, -F, -Cl, -Br, -CN, -NO₂ or -OH, C₅-C₃₀ heterocycloalkyl groups unsubstituted or substituted with C₁-C₂₀ alkyl, C₁-C₂₀ alkoxy, -F, -Cl, -Br, -CN, -NO₂ or -OH, and groups represented by -N(G₁)(G₂) (where G₁ and G₂ may be each independently hydrogen, a C₁-C₁₀ alkyl group or a C₆-C₃₀ aryl group unsubstituted or substituted with C₁-C₁₀ alkyl).

The term "alkyl" used herein includes straight, branched, cyclic hydrocarbon radicals, and combinations thereof. The term may optionally include one or more double bonds, triple bonds or a combination thereof in the chain. That is, "alkyl" is intended to include alkenyl and alkynyl.

The term "heteroalkyl", by itself or in combination with another term, means, unless otherwise stated, a stable straight, branched, cyclic hydrocarbon radical or a combination thereof, consisting of one or more carbon atoms and one or more heteroatoms selected from the group consisting of O, N, P, Si, and S, and wherein the nitrogen, phosphorus, and sulfur atoms may optionally be oxidized and the nitrogen heteroatom may optionally be quaternized.

The terms "cycloalkyl" and "heterocycloalkyl", by themselves or in combination with other terms, represent, unless otherwise stated, cyclic versions of "alkyl" and "heteroalkyl", respectively.

The term "aryl" means, unless otherwise stated, a polyunsaturated, aromatic, hydrocarbon substituent which can be a single ring or multiple rings (from 1 to 3 rings) which are fused together or linked covalently. The term "heteroaryl" refers to aryl groups (or rings) that contain from one to four heteroatoms (in each separate ring in the case of multiple rings) selected from N, O, and S, wherein the nitrogen and sulfur atoms are optionally oxidized, and the nitrogen atom(s) are optionally quaternized. The heteroaryl group can be attached to the remainder of the molecule through a carbon or heteroatom.

The aryl includes a 4- to 7-membered, preferably 5- or 6-membered monocyclic or fused ring. The aryl is also intended to include a structure in which one or more aryl groups are linked via a chemical bond. Specific examples of suitable aryl groups include, but are not limited to, phenyl, naphthyl, biphenyl, anthryl, indenyl, fluorenyl, phenanthryl, triphenylenyl, pyrenyl, perylenyl, chrysenyl, naphthacenyl, and fluoranthenyl.

The heteroaryl includes a 5- or 6-membered monocyclic heteroaryl and a polycyclic heteroaryl fused with one or more benzene rings and may also be partially saturated. The heteroaryl is also intended to include a structure in which one or more heteroaryl groups are linked via a chemical bond. The heteroaryl group includes a divalent aryl group in which the heteroatoms in the ring are oxidized or quaternized to form an N-oxide or a quaternary salt. Examples of suitable heteroaryl groups include, but are not limited to: monocyclic heteroaryl groups such as furyl, thiophenyl, pyrrolyl, imidazolyl, pyrazolyl, thiazolyl, thiadiazolyl, isothiazolyl, isoxazolyl, oxazolyl, oxadiazolyl, triazinyl, tetrazinyl, triazolyl, tetrazolyl, furazanyl, pyridyl, pyrazinyl, pyrimidinyl, and pyridazinyl; polycyclic heteroaryl groups such as benzofuranyl, benzothiophenyl, isobenzofuranyl, benzoimidazolyl, benzothiazolyl , benzoisothiazolyl, benzoisoxazolyl, benzoxazolyl, isoindolyl, indolyl, indazolyl, benzothiadiazolyl, quinolyl, isoquinolyl, cinnolinyl, quinazolinyl, quinoxalinyl, carbazolyl, phenanthridinyl, and benzodioxolyl; their corresponding N-oxides (e.g., pyridyl N-oxide and quinolyl N-oxide); and their quaternary salts.

The substituted or unsubstituted fluorene derivative or substituted or unsubstituted pyrene derivative can be bonded to divinylbenzene to form the polymer, as depicted in Formula 1.

As an example, polymerization with the compound (1-hydroxypyrene) having the structure of Formula 2 may give a structure represented by Formula 18: 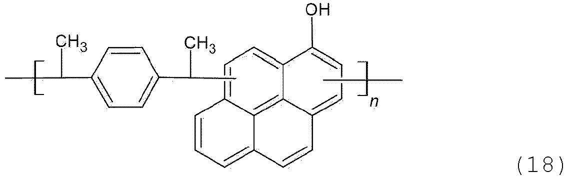 wherein n is an integer from 1 to 10000.

Polymerization with 9,9-bis(4-hydroxyphenyl)fluorene having the structure of Formula 4 and polymerization with 9,9-bis(6-hydroxy-2-naphthyl)fluorene having the structure of Formula 5 may give structures represented by Formula 19 and 20, respectively: 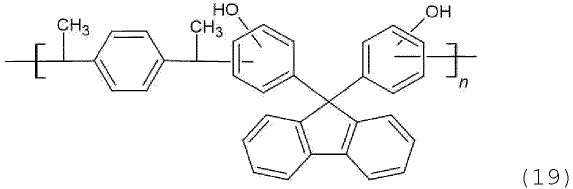
wherein n is an integer from 1 to 10000, 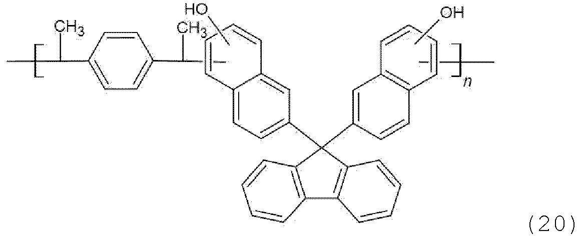
wherein n is an integer from 1 to 10000.

Since each of these polymers has -OH groups attached to some of the benzene ring structures, functional groups can be added by forming ester bonds (through dehydration-condensation reactions). These functional groups can not only change the solubility of the resulting polymer but also the physical properties of a desired hard mask.

The hard mask polymer for semiconductor applications has only the structure of Formula 1 but may be a combination of two or more polymer structures to achieve improved physical properties. For example, the hard mask polymer for semiconductor applications may include a structure represented by Formula 9: 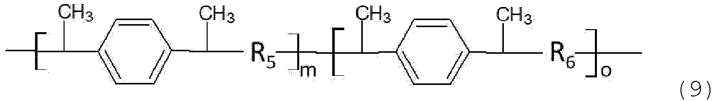 wherein R₅ and R₆ are each independently a substituted or unsubstituted fluorene or a substituted or unsubstituted pyrene and m and o are each independently an integer from 1 to 10000.

The structure of Formula 9 may be a copolymer including two or more structures that can be represented by Formula 1.

Specifically, the hard mask polymer may be a copolymer of a pyrene derivative as R₅ and a fluorene derivative as R₆, represented by Formulas 10 and Formula 11, respectively: 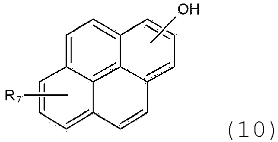
wherein R₇ is H, OH or a C₁-C₅ hydrocarbon, and 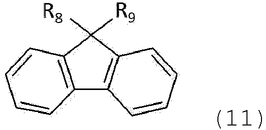
wherein R₈ and R₉ are each independently a benzene, naphthalene or biphenyl unsubstituted or substituted with OH or a C₁-C₅ hydrocarbon, with the proviso that R₈ and R₉ are optionally linked via a hydrocarbon or ether group to form a ring structure or are optionally each independently bonded to each ether.

Specifically, the fluorene derivative having the structure of Formula 11 may be represented by one of Formulas 12 to 16:

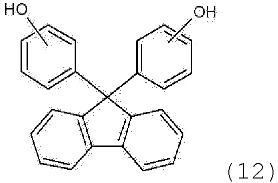

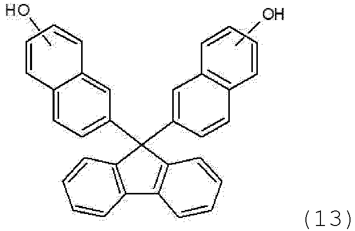

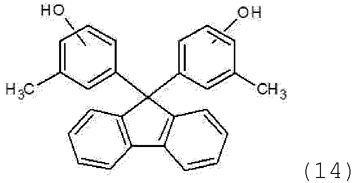

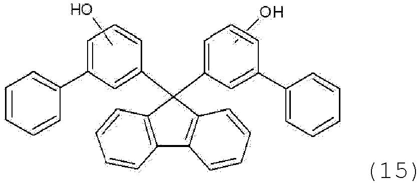

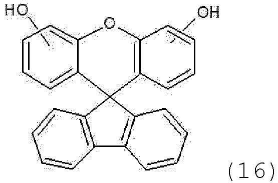

As an example, when R₃ is the structure of Formula 10 and R₄ is the structure of Formula 13, the polymer may have a structure represented by Formula 21: 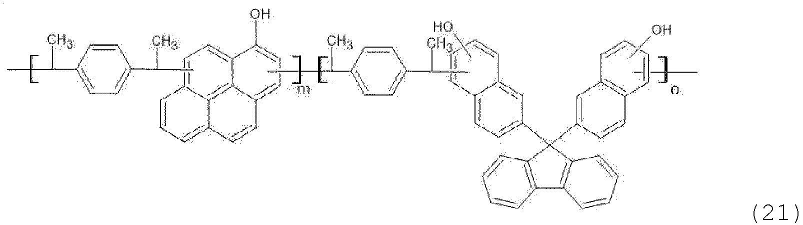 wherein m and o are integers from 1 to 10000.

The hard mask polymer for semiconductor applications may have the structure of Formula 1 or 9. Alternatively, a mixture of a compound having the structure of Formula 1 and a compound having the structure of Formula 9 may be used for control and improvement of physical properties. In this case, the mixing weight ratio of the compound having the structure of Formula 1 to the compound having the structure of Formula 9 may be in the range of 1:2 to 2:1. Within this range, the hard mask compound of the present invention has high etch resistance and can be easily dissolved in a solvent. However, out of this range, the hard mask compound may have poor etch resistance, low solubility in a solvent or low refractive index and extinction coefficient, making its use in forming a hard mask for semiconductor applications difficult.

The hard mask polymer may have a weight average molecular weight of 1,000 to 20,000. The length of the polymer may vary depending on the polymerization time and reaction temperature. The weight average molecular weight of the hard mask polymer may be in the range of 1,000 to 20,000, preferably 3,000 to 7,000, more preferably 4,000 to 6,000. If the weight average molecular weight of the hard mask polymer is less than the lower limit defined above, the polymerization may be incomplete, resulting in deterioration of etch resistance. Meanwhile, if the weight average molecular weight of the hard mask polymer exceeds the upper limit defined above, the solubility of the hard mask polymer in a solvent may be low, making it difficult to use the hard mask polymer for spin coating.

The present invention is also directed to a hard mask composition for semiconductor applications including the hard mask polymer.

The hard mask polymer can be used to prepare a hard mask composition for semiconductor applications. Since conventional hard masks for semiconductor applications require high etch resistance, many of them are formed by chemical vapor deposition (CVD). However, chemical vapor deposition involves a lot of cost because the processing conditions are troublesome and difficult to achieve.

In efforts to overcome this disadvantage, hard mask compositions for semiconductor applications applicable to spin coating are being developed. However, such compositions are difficult to develop because they are required to have strong etch resistance.

Specifically, the use of polymers with high carbon content is necessary to increase the etch resistance of hard masks for semiconductor applications. However, polymers with high carbon content tend to form a network structure or form a solid phase due to attraction between the polymer molecules, disadvantageously resulting in low solubility in solvents. In contrast, due to its high carbon content and high solubility in a solvent, the polymer of the present invention can be used to provide a hard mask composition for semiconductor applications that can be applied to spin coating.

The hard mask composition for semiconductor applications may include 100 parts by weight of an organic solvent, 1 to 20 parts by weight of the hard mask polymer for semiconductor applications, 0.1 to 3 parts by weight of a crosslinking agent, and 0.001 to 0.1 parts by weight of a catalyst.

The organic solvent is used to dissolve the hard mask polymer present in the composition. The organic solvent is preferably used in a weight ratio of 5-100:1 to the polymer, as described above. If the organic solvent is used in an amount of less than 5 times that of the polymer, the viscosity of the composition may be increased, making it difficult to use the composition for spin coating. Meanwhile, if the organic solvent is used in an amount exceeding 100 times that of the polymer, the thickness of a resulting hard mask for semiconductor applications may be excessively reduced, making it impossible for the hard mask to perform its function.

The organic solvent is preferably selected from the group consisting of propylene glycol monomethyl ether (PGME), propylene glycol methyl ether acetate (PGMEA), cyclohexanone, butyrolactone, ethyl lactate, N-methylpyrrolidone (NMP), methyl methoxypropionate (MMP), ethyl ethoxypropionate (EEP), dimethylformamide (DMF), and mixtures thereof. The organic solvent is most preferably propylene glycol methyl ether acetate (PGMEA).

The crosslinking agent is a component that crosslinks the polymer dissolved in the organic solvent. The crosslinking agent may be used in an amount of 0.1 to 3 parts by weight, based on 100 parts by weight of the organic solvent. If the crosslinking agent is used in an amount of less than 0.1 parts by weight, crosslinking is not performed during spin coating, causing poor etch resistance of a resulting hard mask for semiconductor applications. If the crosslinking agent is used in an amount exceeding 3 parts by weight, the hard mask polymer may be crosslinked before spin coating, making it difficult to use the composition for spin coating. The excess crosslinking agent acts as an impurity during formation of a hard mask for semiconductor applications, resulting in poor etch resistance of the hard mask.

The crosslinking agent may be a methylated melamine resin, a methylated urea resin or the glycoluril derivative represented by Formula 17:

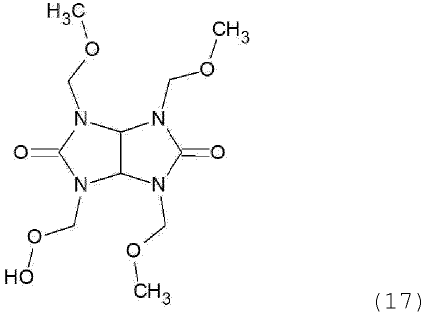

The catalyst is used to promote the crosslinking reaction of the polymer by the crosslinking agent. The catalyst is used in an amount of 0.001 to 0.1 parts by weight, based on 100 parts by weight of the organic solvent. If the amount of the catalyst is less than 0.001 parts by weight, the rate of the crosslinking reaction may be slowed down, making it difficult to form a hard mask at a desired time point. Meanwhile, if the amount of the catalyst exceeds 0.1 parts by weight, the cure rate of the hard mask composition may increase, making it difficult to form a hard mask by spin coating.

The catalyst may be pyridinium p-toluenesulfonate, 2,4,4,6-tetrabromocyclohexadienone, benzoin tosylate or an alkyl ester of an organic sulfonic acid.

The present invention also provides a patterning method using the hard mask composition. As discussed above, the hard mask polymer of the present invention can be used to form a hard mask with good etch resistance and can be easily dissolved in a solvent. Therefore, the hard mask composition of the present invention can be used in a semiconductor patterning process, particularly spin coating.

Preferred embodiments of the present invention will be described in detail with reference to the accompanying drawings such that those skilled in the art can readily practice the invention. In describing the present invention, detailed explanations of a related known function or construction are omitted when it is deemed that they may unnecessarily obscure the essence of the invention. Certain features shown in the drawings are enlarged, reduced or simplified for ease of illustration and the drawings and the elements thereof are not necessarily in proper proportion. However, those skilled in the art will readily understand such details.

### [Example 1]

20 g of 1-hydroxypyrene (Formula 2), 11 g of 1,4-divinylbenzene, and 150 g of propylene glycol monomethyl ether acetate (PGMEA) were placed in a reactor. The inside of the reactor was maintained under a nitrogen atmosphere. Thereafter, 0.5 g of triflic acid was added. The mixture was heated to 140 °C and refluxed for 6 h. After completion of the reaction, the reaction mixture was slowly added dropwise to 1500 g of methanol to precipitate a polymer. The precipitated polymer was collected and dried under vacuum.

### [Example 2]

The procedure of Example 1 was repeated except that 21 g of 1,6-dihydroxypyrene (Formula 2) was used instead of 1-hydroxypyrene.

### [Example 3]

The procedure of Example 1 was repeated except that 32 g of 9,9-bis(4-hydroxyphenyl)fluorene (Formula 3) was used instead of 1-hydroxypyrene.

### [Example 4]

The procedure of Example 1 was repeated except that 40 g of 9,9-bis(6-hydroxy-2-naphthyl)fluorene (Formula 4) was used instead of 1-hydroxypyrene.

### [Example 5]

The procedure of Example 1 was repeated except that 10 g of 1-hydroxypyrene and 20 g of 9,9-bis(6-hydroxy-2-naphthyl)fluorene were used instead of 1-hydroxypyrene.

### [Comparative Example 1]

70 g of PGMEA was added to 20 g of 9,9-bis(4-hydroxyphenyl)fluorene and 9.5 g of 1,4-bismethoxymethylbenzene. To the mixture was added 0.16 g of diethyl sulfate. The subsequent procedure was the same as in Example 1 to synthesize a polymer.

### [Experimental Example 1]

An experiment was conducted to confirm the structures of the high molecular weight polymers prepared in Examples 1-5.

The characteristic peaks of the hydroxypyrene and dihydroxypyrene compounds and the other compounds used in Examples 1-5 were not confirmed even by NMR or FT-IR spectroscopy, which is commonly used to analyze the morphology of molecules, due to the presence of a plurality of benzene ring structures. Thus, the weight average molecular weights of the polymers were measured by gel permeation chromatography (GPC). The results are shown in Table 1.

**Table 1**

| | Example 1 | Example 2 | Example 3 | Example 4 | Example 5 | Comparative Example 1 |
|---|---|---|---|---|---|---|
| Weight average molecular weight | 4,500 | 5,400 | 5,000 | 4,300 | 5,200 | 5,400 |

As can be seen from the results in Table 1, the average molecular weights of the polymers of Examples 1-5 exceeded 4000, demonstrating that the inventive methods are suitable for the preparation of high molecular weight polymers. In addition, the molecular weights of the polymers of Examples 1-5 were suitable for the use of the polymers in forming hard masks for semiconductor applications. The same results were obtained in the polymer of Comparative Example 1, which is an isomer with the same atomic composition but a different molecular shape.

### [Examples 6-12]

An experiment was conducted to compare the performance of hard masks formed using the polymers of Examples 1-5 and Comparative Example 1.

Each of the polymers of Examples 1-5 and Comparative Example 1 was dissolved in PGMEA as a solvent to prepare a hard mask composition for semiconductor applications. The polymer and other components of the composition and their amounts (g) are shown in Table 2.

**Table 2**

| | Example 6 | Example 7 | Example 8 | Example 9 | Example 10 | Example 11 | Example 12 |
|---|---|---|---|---|---|---|---|
| Example 1 | 2.5 | - | - | - | - | 1.3 | - |
| Example 2 | - | 2.5 | - | - | - | - | - |
| Example 3 | - | - | 2.5 | - | - | - | - |
| Example 4 | - | - | - | 2.5 | - | - | - |
| Example 5 | - | - | - | - | 2.5 | 1.2 | - |
| Comparative Example 1 | - | - | - | - | - | - | 2.5 |
| Solvent | 46.5 | 46.5 | 46.5 | 46.5 | 46.5 | 46.5 | 46.5 |
| Crosslinking agent | 1 | 1 | 1 | 1 | 1 | 1 | 1 |
| Catalyst | 0.01 | 0.01 | 0.01 | 0.01 | 0.01 | 0.01 | 0.01 |

PGMEA was used as the solvent, the glycoluril derivative of Formula 15 was used as the crosslinking agent, and pyridinium p-toluenesulfonate was used as the catalyst.

### [Experimental Example 2]

Each of the hard mask compositions prepared in Examples 6-12 was coated on a silicon wafer by spin coating. Thereafter, the coated composition was heated at 240 °C for 1 min and subsequently at 400 °C for 1 min on a hot plate to form a hard mask.

The refractive indices n and extinction coefficients k of the hard masks formed using the compositions of Examples 6-12 were measured. The results are shown in Table 3. An ellipsometer and a light source with a wavelength of 193 nm were used in this experiment.

**Table 3**

| | Refractive index (*n*) | Extinction coefficient (*k*) |
|---|---|---|
| Example 6 | 1.43 | 0.49 |
| Example 7 | 1.32 | 0.44 |
| Example 8 | 1.45 | 0.46 |
| Example 9 | 1.35 | 0.39 |
| Example 10 | 1.42 | 0.50 |
| Example 11 | 1.43 | 0.48 |
| Example 12 | 1.44 | 0.90 |

As can be seen from the results in Table 3, the compositions of Examples 6-10, which included the polymers of Examples 1-5, respectively, had appropriate refractive indices and extinction coefficients for use in hard masks for semiconductor applications. It was also confirmed that the composition of Example 11, which included a mixture of the polymers of Examples 1 and 5, could be used to form a hard mask. It was, however, confirmed that the hard mask formed using the composition of Example 12, which was prepared using 1,4-bismethoxymethylbenzene instead of divinylbenzene, showed poor performance due to its high extinction coefficient.

The hard masks formed using the compositions of Examples 6-12 were evaluated for dry etch resistance.

The hard masks formed using the compositions of Examples 6-12 were dry etched using CF₄ gas on dry etch equipment for 10 sec. The dry etch rate was defined as (the thickness of the film before dry etching - the thickness of the film after dry etching)/time. The dry etch performance was defined as the dry etch rate of each of the compositions of Examples 6-11/the dry etch rate of the composition of Example 12. The calculation results are shown in Table 4.

**Table 4**

| | Etch rate (A/s) | Etch performance (%) |
|---|---|---|
| Example 6 | 69.1 | 92 |
| Example 7 | 69.8 | 93 |
| Example 8 | 65.2 | 87 |
| Example 9 | 68.3 | 91 |
| Example 10 | 67.5 | 90 |
| Example 11 | 66.1 | 88 |
| Example 12 | 75.0 | 100 |

As can be seen from the results in Table 4, the use of the polymers of Examples 1-5 led to a reduction in etch rate compared to the use of the polymer of Comparative Example 1, indicating enhanced etch resistance of the polymers of Examples 1-5 during dry etching. In conclusion, the inventive hard mask polymers sand the inventive compositions prepared using the polymers have high etch resistance.

### [Examples 13-23]

An experiment was conducted to determine the effects of the amounts of the components in the preparation of the corresponding compositions. In this experiment, the polymer of Example 1 was used and the components were mixed in the amounts (g) shown in Table 5.

**Table 5**

| | Example 1 | Solvent | Crosslinking agent | Catalyst |
|---|---|---|---|---|
| Example 13 | 0.2 | 46.5 | 1 | 0.01 |
| Example 14 | 1.0 | 46.5 | 1 | 0.01 |
| Example 15 | 2.5 | 46.5 | 1 | 0.01 |
| Example 16 | 6.5 | 46.5 | 1 | 0.01 |
| Example 17 | 11.0 | 46.5 | 1 | 0.01 |
| Example 18 | 2.5 | 46.5 | 0.01 | 0.01 |
| Example 19 | 2.5 | 46.5 | 0.1 | 0.01 |
| Example 20 | 2.5 | 46.5 | 1.5 | 0.01 |
| Example 21 | 2.5 | 46.5 | 1 | 0 |
| Example 22 | 2.5 | 46.5 | 1 | 0.005 |
| Example 23 | 2.5 | 46.5 | 1 | 0.05 |

### Experimental Example 3

The procedure of Experimental Example 2 was repeated except that the compositions of Examples 13-23 were used to determine whether they were suitable for use in forming hard masks. The results are shown in Table 6.

**Table 6**

| | Refractive index (*n*) | Extinction coefficient (*k*) | Etch rate (A/s) | Etch performance (%) |
|---|---|---|---|---|
| Example 13 | 1.89 | 0.68 | - | - |
| Example 14 | 1.42 | 0.51 | 73.5 | 98 |
| Example 15 | 1.43 | 0.49 | 69.2 | 92 |
| Example 16 | 1.42 | 0.44 | 65.3 | 87 |
| Example 17 | - | - | - | - |
| Example 18 | 1.44 | 0.39 | 76.5 | 102 |
| Example 19 | 1.38 | 0.40 | 74.3 | 99 |
| Example 20 | 1.46 | 0.72 | 74.2 | 99 |
| Example 21 | - | - | - | - |
| Example 22 | 1.38 | 0.68 | 80.9 | 108 |
| Example 23 | - | - | - | - |

As can be seen from the results in Table 6, the hard mask formed using the composition of Example 15, which was prepared under the same conditions as in Example 6, had suitable physical properties. The hard mask formed using the composition of Example 13 including the excessively small amount of the polymer did not remain after etching, making it impossible to measure its etch rate and performance. This was because the presence of the small amount of the polymer led to too small a thickness of the mask layer. In contrast, spin coating of the composition of Example 17 including the excessively large amount of the polymer was unsuccessful due to the relatively reduced amount of the solvent, making it impossible to proceed with the experiment.

The use of the composition of Example 18 including the excessively small amount of the crosslinking agent was found to cause inferior etch performance compared to the use of the composition including the polymer of Comparative Example 1 commonly used in the art. In contrast, the extinction coefficient of the composition of Example 20 including the excessively large amount of the crosslinking agent was high, making it difficult to use the composition for forming a hard mask.

The composition of Example 21 using the excessively small amount of the catalyst was not completely cured before the completion of the spin coating, failing to form a hard mask. The composition of Example 21 using the excessively large amount of the catalyst was cured prior to the completion of the spin coating, making it difficult to form a hard mask.

Although the particulars of the present invention have been described in detail, it will be obvious to those skilled in the art that such particulars are merely preferred embodiments and are not intended to limit the scope of the present invention. Therefore, the true scope of the present invention is defined by the appended claims and their equivalents.

## Claims

1. A hard mask polymer for semiconductor applications comprising a structure represented by Formula 1: 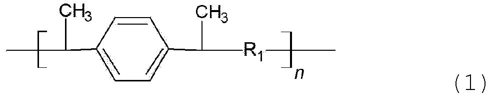 wherein R1 is a hydrocarbon comprising one or more benzene ring structures and n is an integer from 1 to 10000.

2. The hard mask polymer according to claim 1, wherein the hydrocarbon comprising benzene ring structures has a structure represented by Formula 2 or 3: 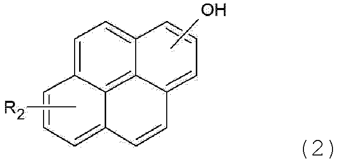
wherein R₂ is H, OH or a C₁-C₅ hydrocarbon, 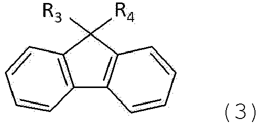
wherein R₃ and R₄ are each independently a benzene, naphthalene or biphenyl unsubstituted or substituted with OH or a C₁-C₅ hydrocarbon, with the proviso that R₃ and R₄ are optionally linked via a hydrocarbon or ether group to form a ring structure or are optionally each independently bonded to each other.

3. The hard mask polymer according to claim 2, wherein the structure of Formula 3 is represented by one of Formulas 4 to 8:

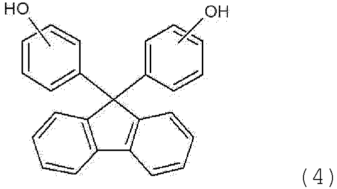

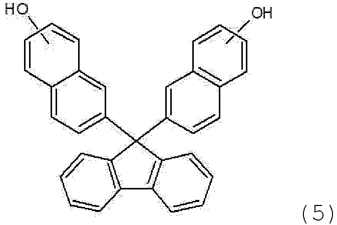

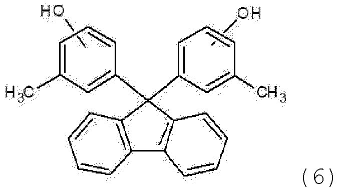

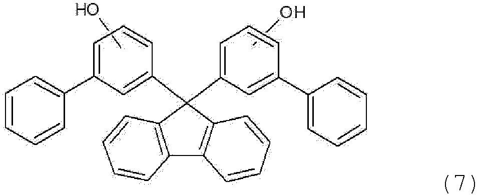

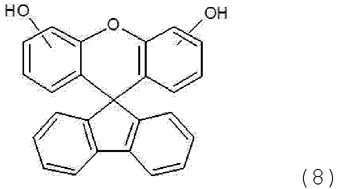

4. The hard mask polymer according to claim 1, wherein the hard mask polymer comprises a structure represented by Formula 9: 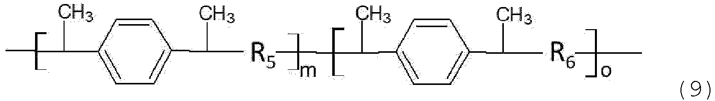 wherein R₅ and R₆ are each independently a hydrocarbon comprising benzene ring structures and m and o are each independently an integer from 1 to 10000.

5. The hard mask polymer according to claim 4, wherein R₅ has a structure represented by Formula 10: 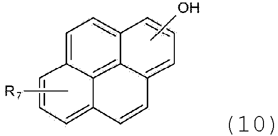
wherein R₇ is H, OH or a C₁-C₅ hydrocarbon, and
R₆ has a structure represented by Formula 11: 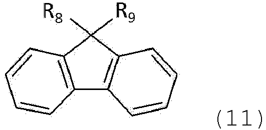
wherein R₈ and R₉ are each independently a benzene, naphthalene or biphenyl unsubstituted or substituted with OH or a C₁-C₅ hydrocarbon, with the proviso that R₈ and R₉ are optionally linked via a hydrocarbon or ether group to form a ring structure or are optionally each independently bonded to each ether.

6. The hard mask polymer according to claim 5, wherein the structure of Formula 11 is represented by one of Formulas 12 to 16:

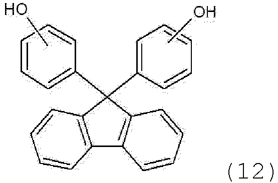

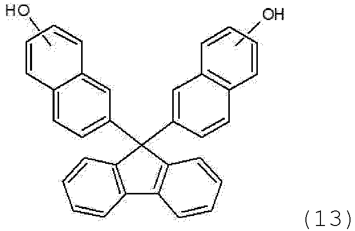

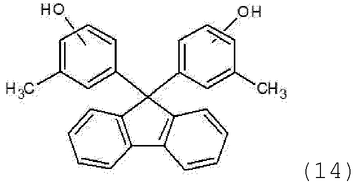

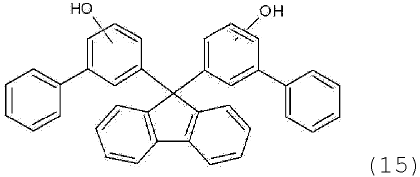

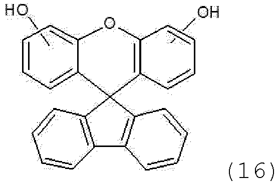

7. The hard mask polymer according to claim 1, wherein the hard mask polymer has a weight average molecular weight of 1,000 to 20,000.

8. A hard mask composition for semiconductor applications comprising the hard mask polymer according to any one of claims 1 to 7.

9. The hard mask composition according to claim 8, wherein the hard mask composition comprises 100 parts by weight of an organic solvent, 1 to 20 parts by weight of the hard mask polymer, 0.1 to 3 parts by weight of a crosslinking agent, and 0.001 to 0.1 parts by weight of a catalyst.

10. The hard mask composition according to claim 9, wherein the organic solvent is selected from the group consisting of propylene glycol monomethyl ether (PGME), propylene glycol methyl ether acetate (PGMEA), cyclohexanone, butyrolactone, ethyl lactate, N-methylpyrrolidone (NMP), methyl methoxypropionate (MMP), ethyl ethoxypropionate (EEP), dimethylformamide (DMF), and mixtures thereof.

11. The hard mask composition according to claim 9, wherein the crosslinking agent is a methylated melamine resin, a methylated urea resin or the glycoluril derivative represented by Formula 17:

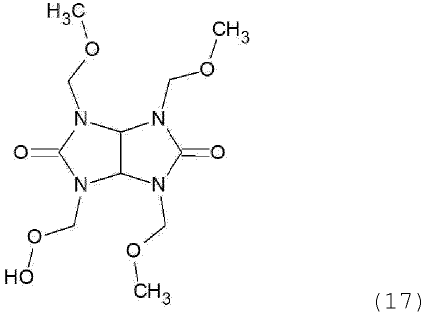

12. The hard mask composition according to claim 9, wherein the catalyst is pyridinium p-toluenesulfonate, 2,4,4,6-tetrabromocyclohexadienone, benzoin tosylate or an alkyl ester of an organic sulfonic acid.

13. A patterning method using the hard mask composition according to claim 8.
